# EUROPÄISCHE PATENTSCHRIFT

(11) **EP 2 441 173 B1**
(45) Veröffentlichungstag und Bekanntmachung des Hinweises auf die Patenterteilung: **08.04.2020**
(21) Anmeldenummer: 10773866.8
(22) Anmeldetag: 09.06.2010
(51) Int. Cl.: H01S 5/042, H01S 5/40, H03K 3/57

(54) **VORRICHTUNG ZUR ANSTEUERUNG EINES LASERDIODENARRAYS**
DEVICE FOR ACTUATING A LASER DIODE ARRAY
DISPOSITIF DE COMMANDE D'UN RÉSEAU DE DIODES LASER

(30) Priorität: 12.06.2009 DE 202009008337 U
(43) Veröffentlichungstag der Anmeldung: 18.04.2012
(73) Patentinhaber: Picolas GmbH, 52134 Herzogenrath-Kohlscheid (DE); Wieland, Wilfried, 75334 Straubenhardt (DE)
(72) Erfinder: WIELAND, Wilfried, 75334 Straubenhardt (DE); BARTRAM, Markus, 52134 Herzogenrath-Kohlscheid (DE)
(74) Vertreter: Jostarndt Patentanwalts-AG
(86) Internationale Anmeldenummer: PCT/EP2010/058049
(87) Internationale Veröffentlichungsnummer: WO 2010/142708

(56) Entgegenhaltungen:
- WO-A2-03/106826
- WO-A2-03/106826
- WO-A2-2004/102659
- US-A- 5 206 455
- US-A- 5 463 648
- US-A1- 2006 263 584

## Beschreibung

### Technisches Gebiet

Die Erfindung betrifft eine Vorrichtung zur Ansteuerung einer Laserdiode bzw. eines horizontalen Arrays mehrerer epitaktisch verbundener Laserdioden (Array)

### Hintergrund der Erfindung

Insbesondere im Hinblick auf die Größe und die Bauform von Lasersystemen erfährt das Gebiet der Lasertechnologie derzeit starke Veränderungen. Lasersysteme werden kleiner, kompakter, preiswerter und vor allem portabel. Hochleistungsdiodenlaser ersetzen immer häufiger hochkomplexe und komplizierte Lasersysteme, wie beispielsweise Gas- oder Festkörperlaser. Eine wichtige Komponente eines Hochleistungsdiodenlasers bildet dabei die Laserdiode, die in Kombination mit einer Leistungselektronik betrieben wird.

Bei einer Laserdiode handelt es sich um ein Halbleiterbauelement, das durch die Zuführung eines elektrischen Gleichstromes Laserlicht erzeugt. Dieser Gleichstrom kann auch ultrakurz gepulst zugeführt werden, um einen zeitlich äquivalenten Laserpuls zu erreichen. Derartige kurze Pulse können für die Dauer des Pulses um ein vielfaches höher sein, als der zulässige mittlere Dauer-Gleichstrom. Dauer und Pulsspitzenleistung werden durch die Anwendung bestimmt.

WO 03/106826 A2 offenbart eine Vorrichtung zur Ansteuerung eine Laserdiode, die eine elektrische Schaltung zur Erzeugung eines gepulsten Ausgangssignals umfasst, wobei die Pulsform durch ein passives pulsformgebendes Netzwerk bestimmt wird.

### Darstellung der Erfindung

Eine Aufgabe der Erfindung ist es daher, eine Treiberstufe für die Ansteuerung einer Laserdiode bereitzustellen, die für eine Funktion einen kurzen sehr leistungsfähigen Strompuls bereitstellen kann.

Diese Aufgabe wird gelöst durch eine Vorrichtung mit den Merkmalen des unabhängigen Anspruchs 1. Vorteilhafte Weiterbildungen ergeben sich aus den Unteransprüchen 2 bis 11.

Die Vorrichtung zur Ansteuerung einer Laserdiode umfasst eine elektrische Schaltung zur Erzeugung eines gepulsten Ausgangssignals, an die ein voreinstellbarer Triggerimpuls anlegbar ist. Dabei wird aus einer zuvor angelegten Hochspannung über ein pulsformgebendes passives Netzwerk (Pulse-Forming-Network, PFN) ein definierter Strompuls ausgelöst. Dieser Strompuls wird über eine niedriginduktive Leiterplatte zu einer Laserdiode geführt.

Der Nennstrom durch die Laserdiode wird dabei durch die Höhe der Hochspannung in Verbindung mit dem definierten festen Widerstandsbestandteil (210...21x) bestimmt. Diese Technik gewährleistet einen überschwingungsfreien schnellen Anstieg gegen die parasitäre Induktivität der Zuleitung in, an und um die Laserdiode.

Dabei ist der Ballastwiderstand 210-21x einer besonderen Pulsbelastung ausgesetzt, die den Einsatz von klassischen (Dickschicht-) Widerständen ausschließt. Die Erfindung beinhaltet eine Vorrichtung, die dadurch gekennzeichnet, dass der Ballastwiderstand aus einer dünnen Folie mit, niederinduktiver mäanderfreier Struktur besteht, die der Pulsspitzenleistung standhält. Diese Folie ist typischerweise auf einen Keramikträger aufgebracht und in Flip-Chip-Technik auf die Platine gelötet. Alternativ kann diese Metallfolie auch als Bestandteil des Platinen- oder Keramikbauteilträgers herstellungsseitig ausgeführt werden.

Bei der Vorrichtung zur Ansteuerung einer oder mehrerer Laserdioden - insbesondere eines Laserdiodenarrays - handelt es sich um eine Vorrichtung, die eine elektrische Schaltung zur Erzeugung eines gepulsten Ausgangssignals umfasst, wobei an die Vorrichtung ein voreinstellbarer Triggerimpuls anlegbar ist.

Erfindungsgemäß zeichnet sich die Vorrichtung dadurch aus, dass die Pulsform durch ein passives pulsformgebendes Netzwerk (pulse forming Network, PFN) bestimmt wird.

Die Erfindung beinhaltet eine Vorrichtung mit mehreren, jedoch mindestens zwei, parallel geschalteten diskreten oder integrierten Bauteilen. In der Prinzipskizze ist dies beispielhaft dargestellt als Bauteile 201-209, 210-219, 220-229.

Zwischen den einzelnen Bauteilen können funktionsgruppenabhängige elektrisch leitende Verbindungen bestehen.

Eine bevorzugte Weiterbildung der Erfindung beinhaltet eine Vorrichtung, wobei Teile des PFN (insbesondere die Steuerinduktivitäten 220-22x und die Kapazitäten 201-20x) fester Bestandteil der Platine sind oder parasitäre Eigenschaften der verwendeten Bauteile die Pulsform beeinflussen.

Eine bevorzugte Weiterbildung der Erfindung beinhaltet eine Vorrichtung, wobei Teile des PFN als leitfähige Schicht auf der Platine (insbesondere Begrenzungswiderstände) ausgeführt sind.

Eine bevorzugte Weiterbildung der Erfindung beinhaltet eine Vorrichtung, wobei die Ballastwiderstände als impulsfester Widerstand beispielsweise durch einen NiCr-Metallfilmwiderstand einzeln oder zusammen auf einem Keramikträger, durch andere Widerstandslegierungen, durch Integration von Metallfolien in die Leiterplatte oder durch Ausnutzung anderer widerstandsbildender Effekte auf oder in der Leiterplatte (z.B. dünne Kupferfäden) umgesetzt wird.

Eine bevorzugte Weiterbildung der Erfindung beinhaltet eine Vorrichtung, wobei der Ballastwiderstand als Einzelwiderstände oder ein Kombinationsbauteil als Flip-Chip-Bauteil mit der Metallisierung zur Platinenseite aufgelötet wird oder durch andere Maßnahmen die HF-Eigenschaften bzw. die niedrige Streuinduktivität gewährleistet werden.

Eine bevorzugte Weiterbildung der Erfindung beinhaltet eine Vorrichtung, wobei die Energiespeicher das PFN über passive Widerstände aus einer Hochspannungsquelle nachgeladen werden.

Eine bevorzugte Weiterbildung der Erfindung beinhaltet eine Vorrichtung, wobei die Nachladung der Energiespeicher des PFN über eine Schaltregler-Topologie, vorzugsweise einen Hochsetzsteller (Boost-converter), erfolgt.

Eine bevorzugte Weiterbildung der Erfindung beinhaltet eine Vorrichtung, wobei schnelle Halbleiterschalter als MOSFETs in Directfet-Technologie, Flip-Chip oder bare-Die Technik ausgeführt sind.

Eine bevorzugte Weiterbildung der Erfindung beinhaltet eine Vorrichtung, wobei die schnellen Halbleiterschalter durch schnelle Steuerbausteine (Gatetreiber oder schnelle Operationsverstärker) unmittelbar auf der Platine angesteuert werden.

Eine bevorzugte Weiterbildung der Erfindung beinhaltet eine Vorrichtung, wobei durch Maßnahmen sichergestellt ist, dass die Laserdiode symmetrisch mit allen Emittern gleichmäßig bestromt wird. Dies beinhaltet eine geregelte Stromversorgung.

Eine bevorzugte Weiterbildung der Erfindung beinhaltet eine Vorrichtung, wobei die elektrische Schaltung auf einer Platine angeordnet ist, die eine Beschichtung aufweist.

Eine bevorzugte Weiterbildung der Erfindung beinhaltet eine Vorrichtung, wobei die Beschichtung eine metallische Folie umfasst.

Eine bevorzugte Weiterbildung der Erfindung beinhaltet eine Vorrichtung, wobei die Platine so ausgeführt ist, dass die Streuinduktivität unter einem Nanohenry liegt.

Eine bevorzugte Weiterbildung der Erfindung beinhaltet eine Vorrichtung, wobei die elektrische Schaltung auf einer zweiseitigen Platine angeordnet ist.

Eine bevorzugte Weiterbildung der Erfindung beinhaltet eine Vorrichtung, wobei die Platine so wärmeleitend ausgeführt ist, dass die Laserdiode elektrisch isoliert, aber thermisch kontaktierbar ist.

Eine bevorzugte Weiterbildung der Erfindung beinhaltet eine Vorrichtung, wobei die Platine steckbar ausgeführt ist.

Eine bevorzugte Weiterbildung der Erfindung beinhaltet eine Vorrichtung, die ein Mittel zum Anschluss der Laserdiode aufweist.

Eine bevorzugte Weiterbildung der Erfindung beinhaltet eine Vorrichtung, auf die die ungehauste Laserdiode unmittelbar aufgelötet oder leitfähig aufgebracht werden kann.

Eine bevorzugte Weiterbildung der Erfindung beinhaltet eine Vorrichtung, wobei die Laserdiode auf der Platine elektrisch isoliert ist.

Eine bevorzugte Weiterbildung der Erfindung beinhaltet eine Vorrichtung, wobei die Baugruppen mehrfach parallel geschaltet bzw. redundanzerhöhend verwendet werden.

Die Pulsdauer wird durch die Zeitkonstanten des Quotienten der Summe der kapazitiven und induktiven Bauteile (201-20x und 220-22x) bestimmt. Durch das resonante Umschwingen der Kondensatoren wird dynamisch eine hohe Gegenspannung zum Pulsende bereitgestellt, so dass die Pulsflanken in etwa symmetrisch sind.

Zur weiteren Verringerung der parasitären Einflüsse können die vorgenannten Baugruppen, insbesondere die Teile 201, 210, 220, 231, 233, und 236 mehrfach parallel und redundant ausgeführt sein.

Eine Weiterbildung der Vorrichtung sieht eine Anordnung der elektrischen Schaltung auf einer Platine vor, die eine Beschichtung aufweist. Die Beschichtung unterstützt die Ableitung von Wärme, die während einer Anwendung entsteht und schützt die Bauelemente der elektrischen Schaltung vor einer Zerstörung durch Überhitzung. In einer Weiterbildung der Vorrichtung umfasst die Beschichtung eine metallische Folie, die einen guten Wärmeleiter darstellt.

Eine Ausgestaltung der Vorrichtung ist gekennzeichnet durch eine Anordnung der elektrischen Schaltung auf einer zweiseitigen Platine mit dem Ergebnis einer Reduzierung der Größe der Vorrichtung.

Bevorzugt wird diejenige Ausgestaltung eingesetzt, in der die Platine zur Verringerung der Streuinduktivität so dünn wie möglich ausgeführt wird und unmittelbar zwischen die Anschlüsse der Laserdiode gelötet werden kann. Die maximale Dicke der Platine kann sich nach dem Pitch (dem Abstand der Anschlüsse im Laseriodenpackage) richten.

In einer Ausführungsform der Vorrichtung ist die Platine steckbar ausgeführt und ermöglicht so eine direkte Verwendung in einer Schaltungsumgebung. Eine Anbindung über Kabel ist nicht erforderlich.

Eine Weiterbildung der Vorrichtung beinhaltet ein Mittel zum Anschluss der Laserdiode, sodass eine Verbindung über Kabel überflüssig wird.

In einer Ausführungsform der Vorrichtung ist die Laserdiode auf der Platine zur Vermeidung eines Kurzschlusses insbesondere zur Kühlung elektrisch isoliert.

Die zuvor genannten und weitere Vorteile, Besonderheiten und zweckmäßige Weiterbildungen der Erfindung werden auch anhand der Ausführungsbeispiele deutlich, die nachfolgend unter Bezugnahme auf die Figuren beschrieben werden.

### Kurze Beschreibung der Figuren

Von den Figuren zeigt:
- Fig. 1: einen Impulsausgang und das zugehörige optische Signal,
- Fig. 2: ein vereinfachtes Schaltbild eines Laserdiodentreibers.

### Beschreibung von Ausführungsbeispielen

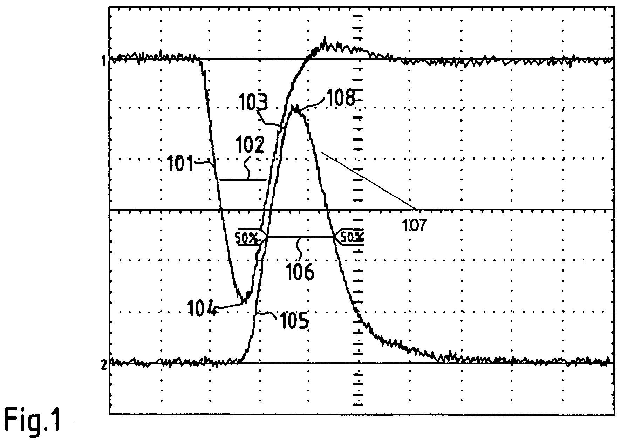

In Fig. 1 ist beispielhaft ein Impulsausgangssignal dargestellt, das an dem integrierten Strommonitor (247) abgreifbar ist, wenn eine Triggerung erfolgte. Sowohl die Impulsanstiegszeit 101 als auch die Impulsabfallzeit 103 sind hier sehr kurz. Dadurch und durch das resonante, stromlose Schalten des MOSFET 233-23x werden Signalverluste vermieden, sodass die in der elektrischen Schaltung entstehende Wärme nur gering ist und dementsprechend eine Kühlung über eine auf die Platine der elektrischen Schaltung aufgebrachte metallische Folie als Beschichtung ausreichend ist. Eine zusätzliche Kühlung der Schaltung über einen Lüfter ist nicht erforderlich.

Eine Verwendung der metallischen Folie in Kombination mit anderen Metallen oder anderen Materialien als mehrlagige Beschichtung ist dann angezeigt, wenn die alleinige Verwendung der metallischen Folie als Beschichtung zur Wärmeableitung nicht ausreichend ist. Auch mit der Verwendung eines Bleches wird eine höhere Wärmeableitung erreicht. Als Materialien für die Beschichtung sind beispielsweise Aluminium, Kupfer oder Silber angezeigt.

Die teilweise Verwendung von Keramikbauteilen in der elektrischen Schaltung des Laserdiodentreibers, beispielsweise die Verwendung von Keramikwiderständen oder Keramikkondensatoren, die auch für einen Einsatz bei höheren Temperaturen geeignet sind, trägt ebenfalls dazu bei, dass eine zusätzliche Kühlung nicht erforderlich ist. Ferner ist die Verwendung von Keramikbauteilen wegen deren günstigen HF-Eigenschaften unabdingbar.

Einen wesentlichen Einfluss auf die Impulsanstiegszeit 101 und die Impulsabfallzeit 103 hat die in den Kabelzuführungen zur Laserdiode entstehende Streuinduktivität. Nur mit einer direkten Anbindung der Laserdiode an den Laserdiodentreiber ohne zusätzliche Kabel wird als Ergebnis das beispielhaft dargestellte Impulsausgangssignal mit dem Verhältnis Spitzenstrom zu Pulsdauer 104/102 erreicht.

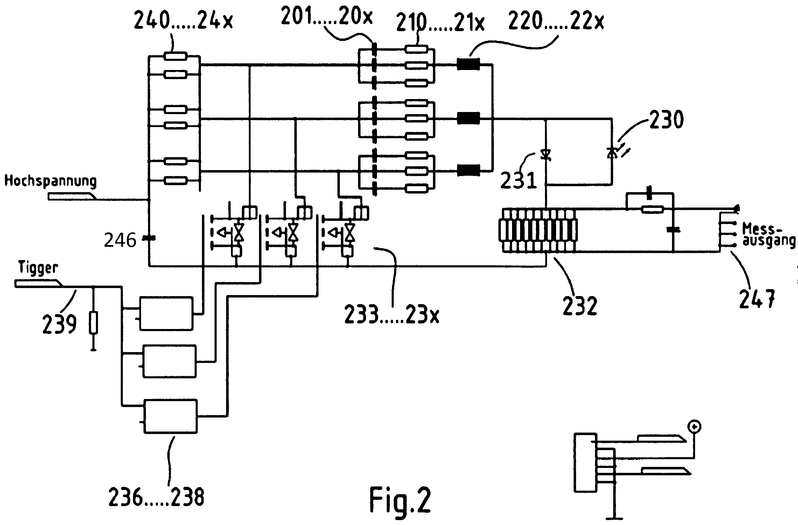

In Fig. 2 ist schematisch das Beispiel eines vereinfachten Schaltbildes eines Laserdiodentreibers dargestellt. Der Ladekondensator 246 wird dabei von einer Hochspannungsquelle aufgeladen. Über Widerstände 240-24x gelangt die Hochspannung auf die Speicherelemente des PFN. Über einen Triggereingang 239 wird ein Triggerimpuls an die elektrische Schaltung angelegt, der optional von einem Verstärker 236-23x noch verstärkt wird, bevor er über den oder die MOSFETs 233-23x zur Leistungsflusssteuerung umgesetzt wird. Der Triggereingang 239 bietet somit die direkte Kontrolle über die MOSFETs 233-23x. Als Verstärker 236-23x wird beispielsweise ein Operationsverstärker (OPV) eingesetzt, der oftmals als integrierte Schaltung angeboten wird und einen geringen Platzbedarf aufweist. Auch die Verwendung eines schnellen HF-Gatetreibers für die Bauteile 236-23x ist denkbar.

Der Triggerimpuls wird beispielsweise über eine lösbare Steckverbindung eingekoppelt. Ein Beispiel für eine lösbare Steckverbindung ist ein Sub-Miniature-C-Steckverbinder (SMC-Steckverbinder) oder ein sog. Pinheader für verdrillte Zweidrahtleitungen (Twisted-Pair).

Infolge des Anlegens des Triggerimpulses 239 an die elektrische Schaltung öffnet sich der als Schalter verwendete Hochgeschwindigkeits-Metalloxid-Feldeffektransistor (MOSFET) 233-23x und es fließt ein Strom aus den PFN-Energiespeichern 201-20x durch die MOSFETs 233-23x, die weiteren Elemente des Resonanznetzwerkes 210-21x und 220-22x, die Laserdiode 230 und die Strommesswiderstände 232. Die Schutzdiode oder die Schutzdioden 231 schützen die Laserdiode 230 vor einem möglichen Rückwärtsstrom und dienen als Freilaufkommutierungspfad zum Abmagnetisieren der Zuleitungsinduktivität. Am Ende des Triggerimpulses schaltet der MOSFET 233-23x wieder ab, der Stromkreis wird unterbrochen und die erneute Aufladung der Energiespeicher 201-20x erfolgt.

Mit der Verwendung eines MOSFET als Schalter werden mögliche Verlustleistungen reduziert und somit die Wärmeentstehung verringert. Als Schalter sind jedoch beispielsweise ebenfalls Feldeffekttransistoren (FET) oder auch bipolare Transistoren einsetzbar.

Optional kann eine Hochspannungsquelle integriert werden, die die erforderliche Hochspannung aus der Versorgung (beispielsweise 15 V) generiert. Die Steuerung der durch die Hochspannungsquelle erzeugten Hochspannung für die Laserdiode kann über ein in die Hochspannungsquelle integriertes Potentiometer erfolgen. Dies ermöglicht eine direkte Regelung der erforderlichen Hochspannung ohne externen Einfluss. Falls eine direkte Regelung nicht möglich ist, wird die Hochspannungsquelle über ein externes Signal gesteuert.

Für die Funktion des Laserdiodentreibers sind dann nur zwei Signale erforderlich, die an der Hochspannungsquelle anliegende Versorgungsspannung und der am Triggereingang 239 anliegende Triggerimpuls. Alle weiteren Signale werden direkt in der elektrischen Schaltung des Laserdiodentreibers generiert.

Der erzeugte Laserdiodenstrom ist abhängig von der angelegten Hochspannung, der Bürdenspannung der Laserdiode 230 und deren Innenwiderstand. Dabei gilt, je höher die angelegte Hochspannung umso höher der Laserdiodenstrom.

Der Laserdiodenstrom wird über die Strommesswiderstände 232 gemessen und überwacht. Die Bestimmung des Laserdiodenstromes ermöglicht eine Ermittlung des Aussteuergrades der elektrischen Schaltung des Laserdiodentreibers, der das Verhältnis der Triggerimpulsdauer zur Periodendauer des Triggerimpulses angibt.

Die kleinen Abmessungen der elektrischen Schaltung des Laserdiodentreibers ermöglichen eine unkomplizierte Integration in bestehende Anwendungen und die geringe Größe in Kombination mit der Reduzierung der Anzahl der erforderlichen externen Versorgungseinheiten für die Funktion der elektrischen Schaltung ergeben eine hohe Benutzerfreundlichkeit in der Anwendung des Laserdiodentreibers.

### Bezugszeichenliste

- 101: Impulsanstiegszeit
- 102: Impulsdauer
- 103: Impulsabfallzeit
- 104: Impulsspitzenstrom
- 105: opt. Signalanstiegszeit
- 106: opt. Pulsdauer
- 107: opt. Signalabfallzeit
- 108: opt. Pulsspitzenleistung

- 201...20x: kapazitive Energiespeicher des Pulsformbildenden Netzwerkes (PFN)
- 210...21x: Widerstandselemente des PFN
- 220...22x: induktive Resonanzelemente des PFN
- 230: Laserdiode
- 231: Schutzdioden
- 232: Messwiderstände
- 233...23x: MOSFET
- 236...23x: Gatetreiber
- 239: Triggereingang
- 240...24x: Nachladewiderstände
- 246: Hochspannungsspeicher
- 247: Messausgang

## Patentansprüche

1. Vorrichtung zur Ansteuerung einer Laserdiode (230), die eine elektrische Schaltung zur Erzeugung eines gepulsten Ausgangssignals umfasst, an die ein voreinstellbarer Triggerimpuls (239) anlegbar ist, wobei die elektrische Schaltung umfasst:
einen Ladekondensator (246), der von einer Hochspannungsquelle aufgeladen wird;
ein passives pulsformgebendes Netzwerk, PFN, mit mehreren, jedoch mindestens zwei, parallel geschalteten Bauteilen, jedes Bauteil bestehend aus einer Reihenschaltung eines kapazitiven Energiespeichers (201..20x), eines Widerstandselementes (210...210x), und eines induktiven Resonanzelementes (220...22x);
mehrere, jedoch mindestens zwei, parallel geschaltete Nachladewiderstände (240..24x) über denen die an dem Ladekondensator (246) anliegende Hochspannung gelangt;
mehrere, jedoch mindestens zwei, parallel geschaltete MOSFETs (233..233x), wobei der Triggerimpuls (239) die MOSFETs steuert;
wobei infolge des Anlegens des Triggerimpulses (239) an die elektrische Schaltung die MOSFETs sich öffnen und ein Strom aus den kapazitiven Energiespeichern (201...20x) durch die MOSFETs (233..233x), die Widerstandselemente (210...210x), die induktiven Resonanzelemente (220...22x) und die Laserdiode (230) fließt, und am Ende des Triggerimpulses die MOSFETs wieder abschalten, der Stromkreis unterbrochen wird und die erneute Aufladung der kapazitiven Energiespeicher (201...20x) erfolgt.

2. Vorrichtung nach Anspruch 1, wobei Teile des PFN als leitfähige Schicht auf der Platine ausgeführt sind.

3. Vorrichtung nach Anspruch 1, wobei die Ballastwiderstände (210-21x) als impulsfeste Widerstände beispielsweise durch einen NiCr-Metallfilmwiderstand einzeln oder zusammen auf einem Keramikträger, durch andere Widerstandslegierungen, durch Integration von Metallfolien in die Leiterplatte oder durch Ausnutzung anderer widerstandsbildender Effekte auf oder in der Leiterplatte umgesetzt werden.

4. Vorrichtung nach Anspruch 1, wobei die Nachladung der Energiespeicher des PFN (201-20x) über eine Schaltregler-Topologie, vorzugsweise einen Hochsetzsteller, erfolgt.

5. Vorrichtung nach einem der vorherigen Ansprüche, wobei die schnellen Halbleiterschalter (233-23x) als MOSFETs in Directfet-Technologie, Flip-Chip oder bare-Die Technik ausgeführt sind.

6. Vorrichtung nach Anspruch 1, wobei die elektrische Schaltung auf einer Platine angeordnet ist, die eine Beschichtung aufweist.

7. Vorrichtung nach einem der vorherigen Ansprüche, wobei die elektrische Schaltung auf einer zweiseitigen Platine angeordnet ist.

8. Vorrichtung nach einem der Ansprüche 6 oder 7, wobei die Platine steckbar ausgeführt ist.

9. Vorrichtung nach einem der vorherigen Ansprüche, die ein Mittel zum Anschluss der Laserdiode (230) aufweist.

10. Vorrichtung nach einem der vorherigen Ansprüche, auf die eine ungehauste Laserdiode (230) unmittelbar aufgelötet oder leitfähig aufgebracht werden kann.

11. Vorrichtung nach einem der Ansprüche 6 bis 10, wobei die Laserdiode (230) auf der Platine elektrisch isoliert ist.

## Claims

1. Device for actuating a laser diode (230) which comprises an electrical circuit for generating a pulsed output signal and to which a trigger pulse (239) can be applied, wherein the electrical circuit comprises:
a charging capacitor (246) which is charged from a high-voltage source;
a passive pulse-forming network, PFN, with a plurality of, but at least two, components that are connected in parallel, each component consisting of a capacitive energy store (201..20x), a resistance element (210...210x), and an inductive resonance element (220...22x) which are connected in series;
a plurality of, but at least two, re-charge resistors (240..24x) that are connected in parallel and via which the high voltage applied to the charging capacitor (246) arrives;
a plurality of, but at least two, MOSFETs (233..233x) that are connected in parallel, wherein the trigger pulse (239) controls the MOSFETs;
wherein, as a result of the trigger pulse (239) being applied to the electrical circuit, the MOSFETs open and a current flows from the capacitive energy stores (201...20x), through the MOSFETs (233..233x), the resistance elements (210...210x), the inductive resonance elements (220...22x) and the laser diode (230), and at the end of the trigger pulse the MOSFETs are deactivated again, the electric circuit is interrupted, and the capacitive energy store (201...20x) is re-charged again.

2. Device according to claim 1, wherein parts of the PFN are designed as a conductive layer on the printed circuit board.

3. Device according to claim 1, wherein the ballast resistors (210-21x) are implemented as pulse-resistant resistors, for example individually by the NiCr metal film resistor or together on a ceramic substrate, by other resistance alloys, by integration of metal films in the printed circuit board, or by exploitation of other resistance-forming effects on or in the printed circuit board.

4. Device according to claim 1, wherein the energy store of the PFN (201-20x) is recharged by means of a switching-regulator topology, preferably a boost converter.

5. Device according to any of the preceding claims, wherein the fast semiconductor switches (233-23x) are designed as MOSFETs in DirectFET technology, flip chip or bare die techniques.

6. Device according to claim 1, wherein the electrical circuit is arranged on a printed circuit board which comprises a coating.

7. Device according to any of the preceding claims, wherein the electrical circuit is arranged on a double-sided printed circuit board.

8. Device according to either claim 6 or claim 7, wherein the printed circuit board is designed so as to be pluggable.

9. Device according to any of the preceding claims, comprising a means for connecting the laser diode (230).

10. Device according to any of the preceding claims, onto which an unhoused laser diode (230) can be directly soldered or attached in a conductive manner.

11. Device according to any of claims 6 to 10, wherein the laser diode (230) is electrically isolated on the printed circuit board.

## Revendications

1. Dispositif de pilotage d'une diode laser (230), qui comprend un circuit électrique servant à générer un signal de sortie pulsé, sur lequel une impulsion de déclenchement (239) préréglée peut être appliquée, dans lequel le circuit électrique comprend :
un condensateur de charge (246), qui est chargé par une source de haute tension ;
un réseau de façonnage d'impulsion passif, PFN, avec plusieurs, toutefois au moins deux, composants branchés en parallèle, chaque composant étant constitué d'un circuit en série d'un accumulateur d'énergie capacitif (201... 20x), d'un élément de résistance (210 ... 210x), et d'un élément résonant inductif (220...22x) ;
plusieurs, toutefois au moins deux, résistances de recharge (240...24x) montées en parallèle, par l'intermédiaire desquelles la haute tension appliquée sur le condensateur de charge (246) parvient ;
plusieurs, toutefois au moins deux, MOSFET (233...233x) branchés en parallèle, dans lequel l'impulsion de déclenchement (239) commande les MOSFET ;
dans lequel suite à l'application de l'impulsion de déclenchement (239) sur le circuit électrique, les MOSFET s'ouvrent et un courant provenant des accumulateurs d'énergie capacitifs (201.. 20x) circule à travers les MOSFET (233... 233x), les éléments de résistance (210... 210x), les éléments résonants inductifs (220...22x) et la diode laser (230), et les MOSFET se désactivent à nouveau à la fin de l'impulsion de déclenchement, le circuit électrique est coupé et la recharge des accumulateurs d'énergie capacitifs (201... 20x) reprend.

2. Dispositif selon la revendication 1, dans lequel des parties du PFN sont réalisées en tant que couche conductrice sur la platine.

3. Dispositif selon la revendication 1, dans lequel les résistances de ballast (210-21c) sont transformées par exemple par une résistance à film métallique en NiCr individuellement ou conjointement sur un support en céramique, par d'autres alliages de résistance, par intégration de films métalliques dans la carte de circuits imprimés ou par exploitation d'autres effets de formation de résistance sur ou dans la carte de circuits imprimés.

4. Dispositif selon la revendication 1, dans lequel la recharge des accumulateurs d'énergie du PFN (201 - 20x) est effectuée par l'intermédiaire d'une topologie de régulateur de commutation, de préférence d'un convertisseur élévateur.

5. Dispositif selon l'une quelconque des revendications précédentes, dans lequel les commutateurs semi-conducteurs (233-23x) rapides sont réalisés en tant que MOSFET de la technologie Directfet, de la technique de puce à protubérances ou de puce nue.

6. Dispositif selon la revendication 1, dans lequel le circuit électrique est disposé sur une platine, qui présente un revêtement.

7. Dispositif selon l'une quelconque des revendications précédentes, dans lequel le circuit électrique est disposé sur une platine à deux côtés.

8. Dispositif selon l'une quelconque des revendications 6 ou 7,
dans lequel la platine est réalisée de manière à pouvoir être enfichée.

9. Dispositif selon l'une quelconque des revendications précédentes, qui présente un moyen servant au raccordement de la diode laser (230).

10. Dispositif selon l'une quelconque des revendications précédentes, sur lequel une diode laser (230) nue peut être brasée directement ou appliquée de manière conductrice.

11. Dispositif selon l'une quelconque des revendications 6 à 10, dans lequel la diode laser (230) est isolée électriquement sur la platine.
